(19) Europäisches Patentamt
European Patent Office
Office européen des brevets

(11) **EP 2 418 772 A2**

(12) **EUROPEAN PATENT APPLICATION**

(43) Date of publication:
**15.02.2012 Bulletin 2012/07**

(51) Int Cl.:
***H03H 7/38*** (2006.01)

(21) Application number: **11176613.5**

(22) Date of filing: **04.08.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **09.08.2010 JP 2010178898**

(71) Applicant: **NTT DoCoMo, Inc.**
**Tokyo 100-6150 (JP)**

(72) Inventors:
• **Fukuda, Atsushi**
**Tokyo 100-6150 (JP)**
• **Okazaki, Hiroshi**
**Tokyo 100-6150 (JP)**
• **Narahashi, Shoichi**
**Tokyo 100-6150 (JP)**

(74) Representative: **MERH-IP**
**Matias Erny Reichl Hoffmann**
**Paul-Heyse-Strasse 29**
**80336 München (DE)**

(54) **Variable impedance matching circuit**

(57)     A variable impedance matching circuit includes a series or parallel connection of a fixed inductive element and a first variable capacitive element and a second variable capacitive element connected in series with the serial or parallel connection. The susceptance of the circuit can be changed by changing the capacitances of the variable capacitive elements.

FIG. 1

100

**Description**

TECHNICAL FIELD

The present invention relates to a variable impedance matching circuit used with a device such as an amplifier.

BACKGROUND ART

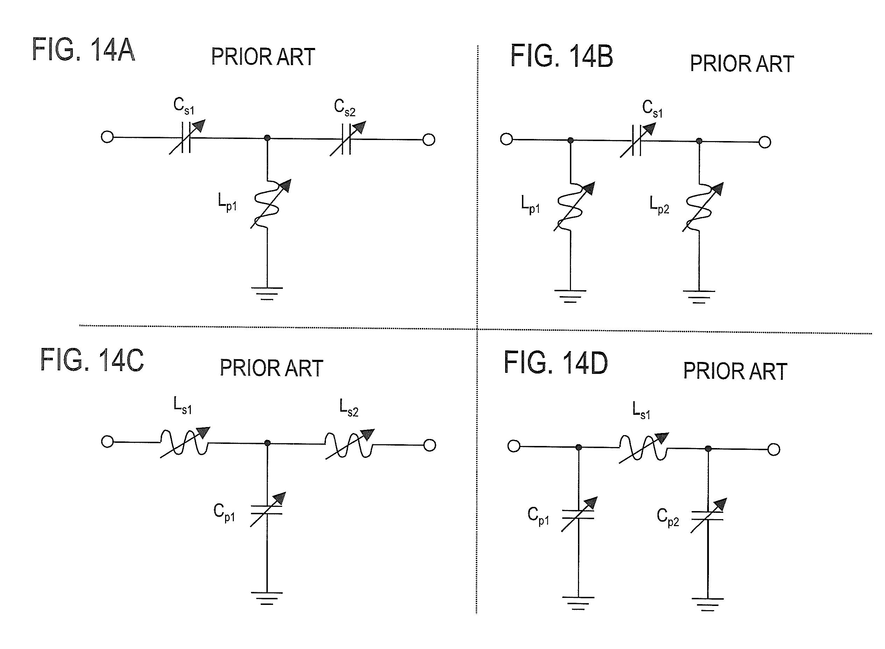

A power amplifier efficiently amplifies the power of a transmission signal to a power level required by a system. Generally, a radio frequency circuit containing a power amplifier is designed so as to match a certain load (impedance $Z_0$). However, a load impedance of a power amplifier especially in a mobile terminal varies according to changes of the electromagnetic environment around the antenna and therefore the output power and efficiency of the amplifier can decrease. There is an art in which a tuner is connected between a power amplifier and an antenna in order to reduce degradation due to variations in load. The tuner is made up of variable devices (variable inductive and capacitive elements). The simplest tuner circuit configurations may be combinations of three elements illustrated in Figs. 14A to 14D. Mathematically, the circuit configurations can deal with any variations in load.

SUMMARY OF THE INVENTION

A sufficiently wide variable range is demanded of a variable device in order to deal with load variations in a sufficiently wide range. However, while a variable inductive element is mathematically conceivable, no practical inductive element has been commercialized as of this writing. In practice, it is difficult to configure the circuits illustrated in Figs. 14A to 14D. Therefore, it has needed to take some measures to deal with load variations in a sufficiently wide range, such as increasing the number of elements used.

An object of the present invention is to provide a variable impedance matching circuit capable of adjusting impedance without using a variable inductive element as if the circuit were using a variable inductive element and accordingly capable of dealing with variations in load in a wide range with a small number of elements.

A variable impedance matching circuit of the present invention includes a series or parallel connection of a fixed inductive element and a first variable capacitive element and a second variable capacitive element connected in series with the series or parallel connection, wherein the susceptance of the circuit can be changed by changing the capacitance of each of the variable capacitive elements.

EFFECTS OF THE INVENTION

The variable impedance matching circuit of the present invention is capable of adjusting impedance without using a variable inductive element as if the circuit were using a variable inductive element. Therefore, the variable impedance matching circuit can deal with load variations in a wide range with a small number of elements.

BRIEF DESCRIPTION OF THE DRAWINGS

Fig. 1 is a diagram illustrating an exemplary configuration of a variable impedance matching circuit 100 of the present invention;
Fig. 2 is a diagram illustrating an exemplary configuration of the variable impedance matching circuit 100 of the present invention combined with a fixed capacitive element;
Fig. 3 is a diagram illustrating variable capacitance value versus absolute susceptance value characteristics in the variable impedance matching circuit 100 of the present invention;
Fig. 4 is a diagram illustrating an exemplary configuration of a variable impedance matching circuit based on the configuration in Fig. 1 capable of supporting two frequency bands;
Fig. 5 is a diagram illustrating an exemplary configuration of a variable impedance matching circuit based on the configuration in Fig. 2 capable of supporting two frequency bands;
Fig. 6 is a diagram illustrating variable capacitance value versus absolute susceptance value characteristics at an input signal frequency of 2 GHz when a switch in the variable impedance matching circuit in Fig. 4 is turned to an $L_{plo\_1}$ side;
Fig. 7 is a diagram illustrating variable capacitance value versus absolute susceptance value characteristics at an input signal frequency of 2 GHz when a switch in the variable impedance matching circuit in Fig. 4 is turned to an $L_{plo\_2}$ side;

Fig. 8 is a diagram illustrating an exemplary configuration of a variable impedance matching circuit 200 of the present invention;

Fig. 9 is a diagram illustrating an exemplary configuration of the variable impedance matching circuit 200 of the present invention combined with a fixed capacitive element;

Fig. 10 is a diagram illustrating variable capacitance value versus absolute susceptance value characteristics in the variable impedance matching circuit 200 of the present invention;

Fig. 11 is a diagram illustrating an exemplary configuration of a variable impedance matching circuit 300 of the present invention;

Fig. 12 is a diagram illustrating an exemplary configuration of the variable impedance matching circuit 300 of the present invention combined with a fixed capacitive element;

Fig. 13 is a diagram illustrating variable capacitance value versus reactance value characteristics in the variable impedance matching circuit 300 of the present invention;

Fig. 14A is a diagram illustrating a first exemplary configuration of a background-art variable impedance matching circuit;

Fig. 14B is a diagram illustrating a second exemplary configuration of a background-art variable impedance matching circuit;

Fig. 14C is a diagram illustrating a third exemplary configuration of a background-art variable impedance matching circuit; and

Fig. 14D is a diagram illustrating a fourth exemplary configuration of a background-art variable impedance matching circuit.

## DETAILED DESCRIPTION OF THE EMBODIMENTS

Embodiments of the present invention will be described below in detail.

[First Embodiment]

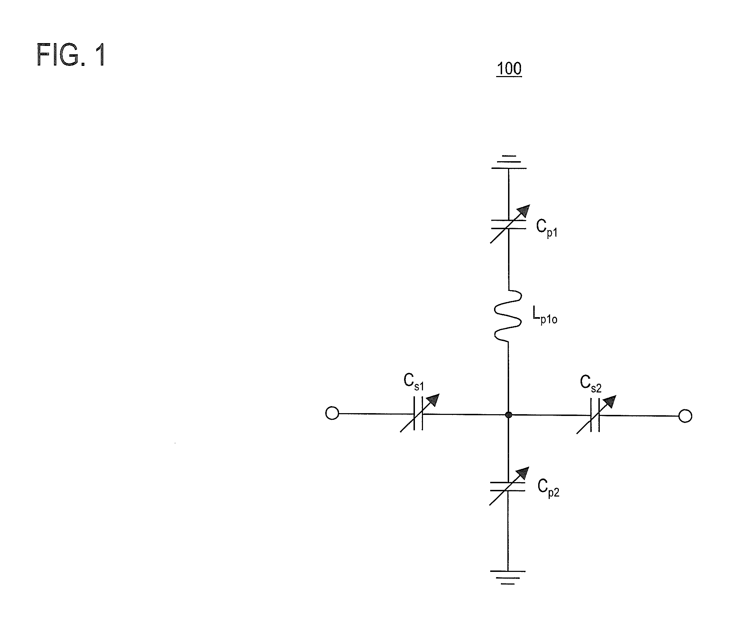

Fig. 1 illustrates an exemplary configuration of a variable impedance matching circuit 100 of the present invention. In the variable impedance matching circuit 100, one fixed inductive element and two variable capacitive elements together act as the variable inductive element $L_{p1}$ of the variable circuit in Fig. 14A.

The variable impedance matching circuit 100 includes a series connection of a variable capacitive elements $C_{s1}$, and $C_{s2}$, and a series connection between a series connection of a fixed inductive element $L_{p1o}$ and a variable capacitive element $C_{p1}$ and a variable capacitive element $C_{p2}$. Both ends of the series connection between the series connection of the fixed inductive element $L_{p1o}$ and the variable capacitive element $C_{p1}$ and the variable capacitive element $Cp_2$ are grounded. The connection point of the series connection of the variable capacitive elements $C_{s1}$, and $C_{s2}$ is connected to the connection point of the series connection between the series connection of the fixed inductive element $L_{p1o}$ and the variable capacitive element $C_{p1}$ and the variable capacitive element $C_{p2}$.

The fixed inductive element $L_{p1o}$ is a fixed inductor having an inductance of $L_{p1o}$. The variable capacitive elements $C_{p1}$ and $C_{p2}$ are variable capacitive elements having capacitances $C_{p1}$ and $C_{p2}$, respectively. The variable capacitive elements may be implemented by semiconductor elements or implemented using MEMS technology, and may be manufactured and configured by any methods.

The admittance $Y_{p1}$ of the series connection of the fixed inductive element $L_{p1o}$ and the variable capacitive element $C_{p1}$ is given by the following expression:

$$Y_{p1} = \frac{j\omega C_{p1}}{1 - \omega^2 L_{p1o} C_{p1}} \qquad (1)$$

where $\omega$ is the angular frequency of an input signal.

The admittance $Y_{p2}$ of the variable capacitive element $C_{p2}$ is given by the following expression:

$$Y_{p2} = j\omega C_{p2} \qquad (2)$$

Therefore, the combined admittance $Y_p$ of $Y_{p1}$ and $Y_{p2}$ is as given below:
$$Y_p = \frac{j\omega C_{p1}}{1 - \omega^2 L_{p1o} C_{p1}} + j\omega C_{p2} \qquad (3)$$

Therefore, $Y_p$ is inductive admittance when the following relational expression holds:
$$-\infty < Y_p \le 0 \qquad (4)$$

Here, from Expressions (3) and (4), the following expressions can be obtained.
$$1 - \omega^2 L_{p1o} C_{p1} \le 0 \qquad (5a)$$

$$-\infty < \frac{j\omega C_{p1}}{1 - \omega^2 L_{p1o} C_{p1}} + j\omega C_{p2} \le 0 \qquad (5b)$$

Furthermore, from Expressions (5a) and (5b) the following expressions can be obtained.
$$C_{p1} \ge \frac{1}{\omega^2 L_{p1o}} \qquad (6a)$$

$$C_{p2} \le \frac{C_{p1}}{\omega^2 L_{p1o} C_{p1} - 1} \qquad (6b)$$

Differentiating the right-hand side of Expression (6b) in $C_{p1}$ yields the following expression.
$$\frac{1}{dC_{p1}}\left\{\frac{C_{p1}}{\omega^2 L_{p1o}C_{p1}-1}\right\} = \frac{-1}{\left(\omega^2 L_{p1o}C_{p1}-1\right)^2} < 0 \qquad (7)$$

Because the right-hand side of Expression (6b) monotonically decreases with respect to $C_{p1}$, the maximum value $C_{p2max}$ of $C_{p2}$ is a minimum when $C_{p1}$ is its maximum value $C_{p1max}$. Therefore, the required ranges of $C_{p1}$ and $C_{p2}$ are:

$$0 \le C_{p1\min} \le \frac{1}{\omega^2 L_{p1o}} \quad \text{and} \quad \frac{1}{\omega^2 L_{p1o}} < C_{p1\max} \qquad (8a)$$

$$C_{p2\min} < \frac{1}{\omega^2 L_{p1o}} \quad \text{and} \quad \frac{1}{\omega^2 L_{p1o}} \le C_{p2\max} \qquad (8b)$$

From the foregoing it follows that $Y_p$ is inductive admittance when $C_{p1}$ is in the range of Expression (8a) and $C_{p2}$ is in the range of Expression (8b). Therefore, the set of the single fixed inductive element $L_{p1o}$ and the two variable capacitive elements $C_{p1}$ and $C_{p2}$ can be caused to function as if the set were a variable inductive element. Thus, the set can act as the variable inductive element $L_{p1}$ in the variable matching circuit in Fig. 14A. A normal variable capacitive element has its specific variable capacitance range. Therefore, variable capacitive elements that have the variable capacitance ranges as given below may be used as $C_{p1}$ and $C_{p2}$:

$$C_{p1\min} \le C_{p1} \le C_{p1\min} + \Delta_{p1} = C_{p1\max} \qquad (9a)$$

$$C_{p2\min} = C_{p2\max} - \Delta_{p2} \le C_{p2} \le C_{p2\max} \qquad (9b)$$

where $\Delta_{p1}$ and $\Delta_{p2}$ are the variable capacitance ranges.

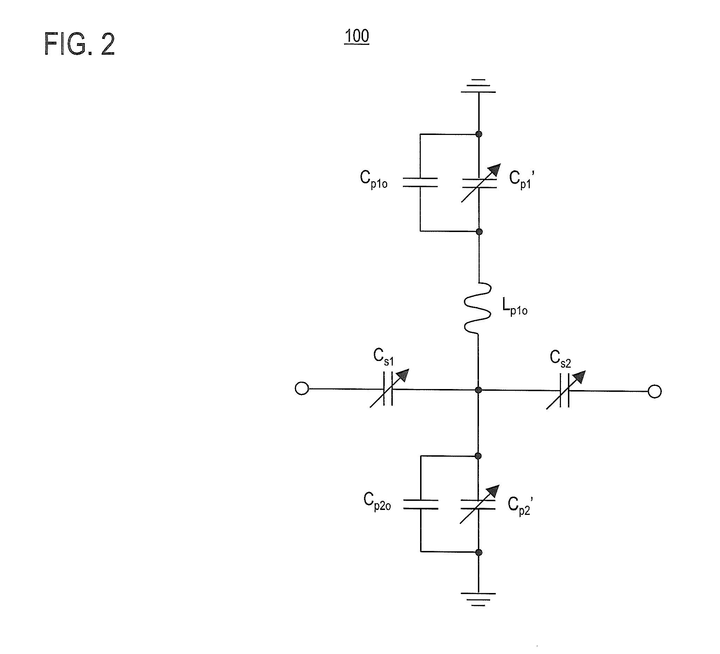

The smaller the absolute value of the capacitance of a variable capacitive element, the smaller the size of the capacitive element. In order to reduce the absolute value of the capacitance, the variable capacitive element $C_{p1}$ may be formed by a fixed capacitive element $C_{p1o}$ ($0 < C_{p1o} \le C_{p1\min}$) and a variable capacitive element $C_{p1}'$ provided in parallel with the fixed capacitive element $C_{p1o}$ and, similarly, the variable capacitive element $C_{p2}$ may be formed by a fixed capacitive element $C_{p2o}$ ($0 < C_{p2o} \le C_{p2\max} - \Delta_{p2}$) and a variable capacitive element $C_{p2}'$ provided in parallel with the fixed capacitive element $C_{p2o}$ as illustrated in Fig. 2. With this configuration, the absolute values of the capacitances of the variable capacitive elements $C_{p1}'$ and $C_{p2}'$ used can be reduced from the absolute values of the capacitances of $C_{p1}$ and $C_{p2}$ in Expressions (9a) and (9b) by $C_{p1o}$ and $C_{p2o}$, respectively, as shown by the expressions given below. With this configuration, smaller variable capacitive elements can be used.

$$C_{p1min} - C_{p1o} \leq C_{p1}' \leq C_{p1min} - C_{p1o} + \Delta_{p1} \qquad (10a)$$

$$C_{p2max} - \Delta_{p2} - C_{p2o} \leq C_{p2}' \leq C_{p2max} - C_{p2o} \qquad (10b)$$

A variable susceptance range that can be obtained by changing $C_{p1}$ and $C_{p2}$ when the set of the single fixed inductive element $L_{p1o}$ and the two variable capacitive elements $C_{p1}$ and $C_{p2}$ in the configuration in Fig. 1 is caused to function as if the set were a variable inductive element will be calculated. Then, the inductance range equivalent to the variable susceptance range that would be achieved only by an inductor will be determined.

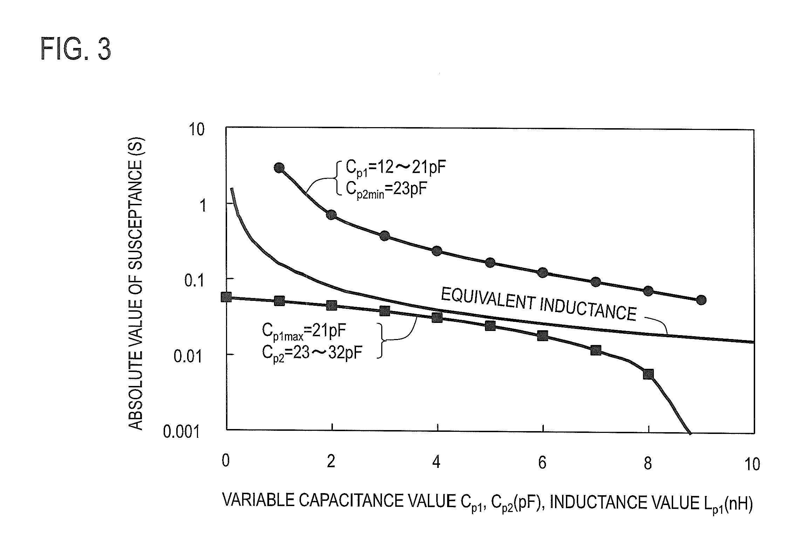

By way of illustration, required $C_{p1}$ and $C_{p2}$ when an input signal frequency is 1 GHz and $L_{p1o}$ is 2 nH will be calculated. From Expression (8a), $C_{p1min}$ is approximately 12.7 pF. For simplicity, assume that $C_{p1min}$ is 12 pF and $\Delta_{p1}$ is 9 pF. Then $12 \leq C_{p1} \leq 21$ pF. Here, since $C_{p1max}$ is 21 pF, $C_{p2max}$ is 31.9 pF from Expression (8b). For simplicity, assume that $C_{p2max}$ is 32 pF and $\Delta_{p2}$ is 9 pF. Then $23 \leq C_{p2} \leq 32$ pF. Fig. 3 illustrates plots of the absolute value of susceptance in the configuration in Fig. 2 in which $C_{p1}$ in Fig. 1 is divided into two, $C_{p1}'$ and $C_{p1o}$, and $C_{p2}$ in Fig. 1 is divided into two, $C_{p2}'$ and $C_{p2o}$, where $C_{p1o} = 12$ pF, $C_{p2o} = 23$ pF, and variable capacitance values $C_{p1}'$ and $C_{p2}'$ are changed in the ranges $\Delta_{p1}$ and $\Delta_{p2}$ (0 to 9 pF), respectively (variable capacitance value versus absolute susceptance value characteristics). The filled circles represent a plot obtained by changing $C_{p1}'$ while $C_{p2}$ is fixed at $C_{p2min}$ (= 23 pF) and filled squares represent a plot obtained by changing $C_{p2}'$ while $C_{p1}$ is fixed at $C_{p1max}$ (= 21 pF). The solid curve without circles nor squares represents the absolute value of susceptance obtained by changing the inductance value equivalent to the variable inductive element $L_{p1}$, in Fig. 14A in the range of 0 to 10 nH. It can be seen from Fig. 3 that susceptance value adjustment in a range equivalent to a range achievable by changing the inductance value $L_{p1}$ by 10 nH or more can be achieved by changing the values of $C_{p1}$ and $C_{p2}$, when the input signal frequency = 1 GHz, $L_{p1o}$ = 2nH, $C_{p1}$ = 12 to 21 pF and $C_{p2}$ = 23 to 32 pF.

The configuration in Fig. 14A has been changed to a configuration that does not use a variable inductive element in the first embodiment described above. The configuration in Fig. 14B also can be changed to a configuration that does not use a variable inductive element in a way similar to that in the first embodiment.

In this way, the variable impedance matching circuit 100 of the present invention is capable of adjusting impedance without using a variable inductive element as if the circuit 100 were using a variable inductive element. Accordingly, the variable impedance matching circuit 100 is capable of dealing with variations in load in a wide range with a small number of elements.

[Variation]

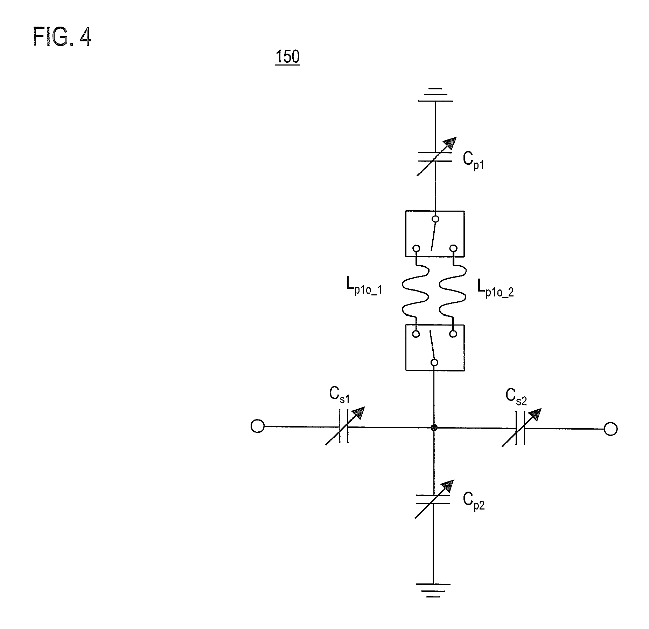

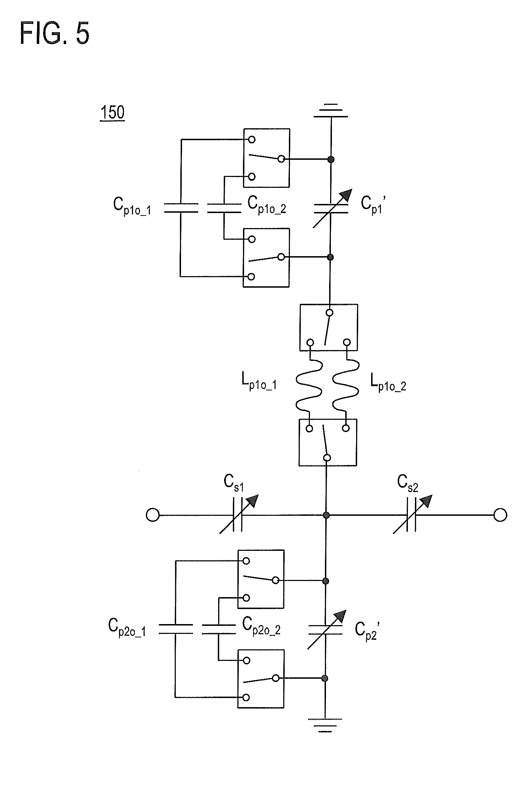

In the variable impedance matching circuit 100 of the present invention, the fixed inductive element $L_{p1o}$ and the fixed capacitive elements $C_{p1o}$ and $C_{p2o}$ are optimized for different frequency bands used and are allowed to be alternately selected by a switch, thereby a variable impedance matching circuit that can be used with multiple frequency bands can be configured. Figs. 4 and 5 illustrate exemplary configurations of a variable impedance matching circuit 150 based on the configurations in Figs. 1 and 2, respectively, that can be used with two frequency bands. In the configuration in Fig. 4, fixed inductive elements $L_{p1o\_1}$ and $L_{p1o\_2}$ can be alternately selected by two SPDT switches according to a frequency band used. In the configuration in Fig. 5, a pair of fixed inductive elements $L_{p1o\_1}$ and $L_{p1o\_2}$, a pair of fixed capacitive elements $C_{p1o\_1}$ and $C_{p1o\_2}$, and a pair of fixed capacitive elements $C_{p2o\_1}$ and $C_{p2o\_2}$ can be alternately selected by two SPDT switches according to a frequency band used.

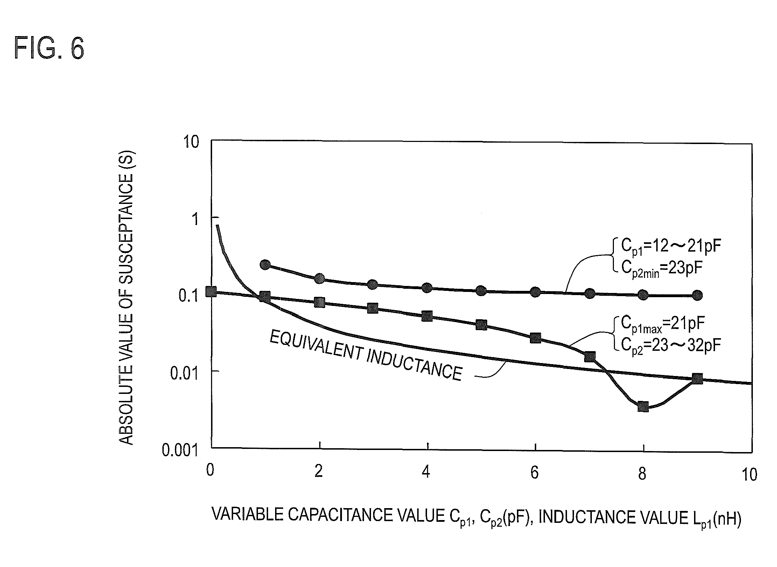

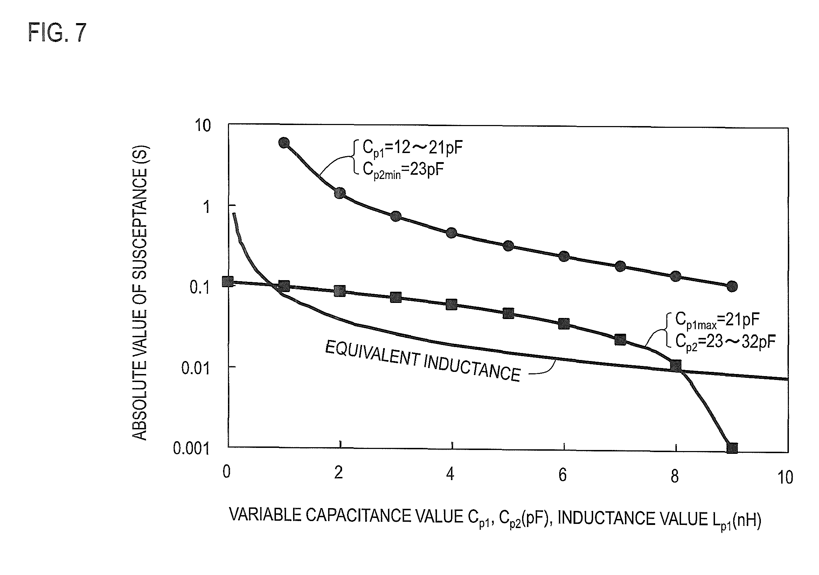

Variable capacitance value versus absolute susceptance value characteristics obtained when the capacitance value of each variable capacitive element in the configuration in Fig. 4 is changed in the same way as in Fig. 3 will be determined. Here, $L_{p1o\_1}$ is 2nH and $L_{p1o\_2}$ is 0.5 nH. When the switches are turned to the $L_{p1o\_1}$ side, the same configuration as that in Fig. 1 is provided. Accordingly, the variable capacitance value versus susceptance absolute value characteristics as illustrated in Fig. 3 are obtained when a signal of a frequency of 1 GHz is input. When a signal of a frequency of 2 GHz is input, the variable capacitance value versus susceptance absolute value characteristics illustrated in Fig. 6 are obtained. It can be seen from Fig. 6 that the range of the susceptance absolute values covered is narrower than the range covered when the 1-GHz signal is input. Fig. 7 illustrates variable capacitance value versus susceptance absolute value characteristics obtained when the switches are turned to the $L_{p1o\_2}$ side to input a signal of a frequency of 2 GHz. It can be seen from Fig. 7 that susceptance absolute values equivalent to the susceptance values obtained with 1 GHz can be obtained with 2 GHz by using $L_{p1o\_2}$ optimized for the input signal of 2 GHz.

[Second Embodiment]

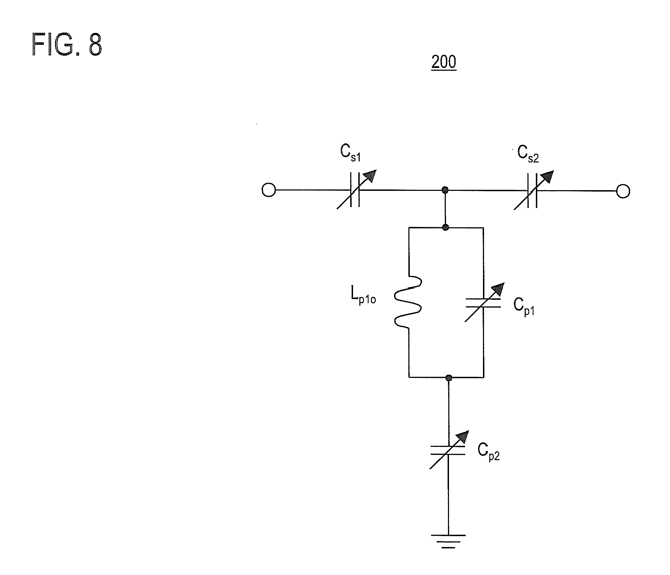

Fig. 8 illustrates an exemplary configuration of a variable impedance matching circuit 200 of the present invention. The variable impedance matching circuit 200 has another configuration in which one fixed inductive element and two variable capacitive elements together act as the variable inductive element $L_{p1}$ in the variable matching circuit in Fig. 14A, as in the first embodiment.

The variable impedance matching circuit 200 includes a series connection of a variable capacitive elements $C_{s1}$, and $C_{s2}$, a series connection between a parallel connection of a fixed inductive element $L_{p1o}$ and a variable capacitive element $C_{p1}$ and a variable capacitive element $C_{p2}$. One end of the series connection between the parallel connection of the fixed inductive element $L_{p1o}$ and the variable capacitive element $C_{p1}$ and the variable capacitive element $C_{p2}$ is connected to the connection point between the variable capacitive elements $C_{s1}$, and $C_{s2}$ and the other end is grounded.

The fixed inductive element $L_{p1o}$ is a fixed inductor with an inductance of $L_{p1o}$. The variable capacitive elements $C_{p1}$ and $C_{p2}$ are variable capacitive elements having capacitances of $C_{p1}$ and $C_{p2}$, respectively. The variable capacitive elements may be implemented by semiconductor elements or implemented using MEMS technology, and may be manufactured and configured by any methods.

The impedance $Z_{p1}$ of the parallel connection of the fixed inductive element $L_{p1o}$ and the variable capacitive element $C_{p1}$ can be given by the following expression.

$$Z_{p1} = \frac{j\omega L_{p1o}}{1 - \omega^2 L_{p1o} C_{p1}} \qquad (11)$$

The impedance $Z_{p2}$ of the variable capacitive element $C_{p2}$ can be given by the following expression.

$$Z_{p2} = \frac{1}{j\omega C_{p2}} \qquad (12)$$

Therefore, the combined impedance $Z_p$ of $Z_{p1}$ and $Z_{p2}$ is as given below.

$$Z_p = \frac{j\omega L_{p1o}}{1 - \omega^2 L_{p1o} C_{p1}} + \frac{1}{j\omega C_{p2}} \qquad (13)$$

Therefore, $Z_p$ is inductive impedance when the following relational expression holds:

$$0 \leq Z_p < \infty \qquad (14)$$

Here, the following expressions can be obtained from Expressions (13) and (14).

$$1 - \omega^2 L_{p1o} C_{p1} \geq 0 \qquad (15a)$$

$$0 \leq \frac{\omega L_{p1o}}{1 - \omega^2 L_{p1o} C_{p1}} - \frac{1}{\omega C_{p2}} < \infty \qquad (15b)$$

Furthermore, the following expressions can be obtained from Expressions (15a) and (15b).
$$C_{p1} \leq \frac{1}{\omega^2 L_{p1o}} \qquad (16a)$$

$$C_{p2} \geq \frac{1 - \omega^2 L_{p1o} C_{p1}}{\omega^2 L_{p1o}} \qquad (16b)$$

Here, differentiating the right-hand side of Expression (16b) in $C_{p1}$ yields the following expression:
$$\frac{1}{dC_{p1}} \left\{ \frac{1 - \omega^2 L_{p1o} C_{p1}}{\omega^2 L_{p1o}} \right\} = -1 \qquad (17)$$

Because the right-hand side of Expression (16b) monotonically decreases with respect to $C_{p1}$, the minimum value $C_{p2min}$ of $C_{p2}$ is a maximum when $C_{p1}$ is its minimum value $C_{p1min}$. Therefore, the required ranges of $C_{p1}$ and $C_{p2}$ are:
$$C_{p1min} < \frac{1}{\omega^2 L_{p1o}} \text{ and } \frac{1}{\omega^2 L_{p1o}} \leq C_{p1max} \qquad (18a)$$

$$0 \leq C_{p2min} \leq \frac{1 - \omega^2 L_{p1o} C_{p1min}}{\omega^2 L_{p1o}} \text{ and } \frac{1 - \omega^2 L_{p1o} C_{p1min}}{\omega^2 L_{p1o}} < C_{p2max} \qquad (18b)$$

From the foregoing it follows that $Z_p$ is inductive impedance when $C_{p1}$ is in the range of Expression (18a) and

$C_{p2}$ is in the range of Expression (18b). Therefore, the set of the single fixed inductive element $L_{p1o}$ and the two variable capacitive elements $C_{p1}$ and $C_{p2}$ can be caused to function as if the set were a variable inductive element. Thus, the set can act as the variable inductive element $L_{p1}$ in the variable matching circuit in Fig. 14A. A normal variable capacitive element has its specific variable capacitance range. Therefore, variable capacitive elements that have the variable capacitance ranges as given below may be used as $C_{p1}$ and $C_{p2}$:

$$C_{p1\min} = C_{p1\max} - \Delta_{p1} \leq C_{p1} \leq C_{p1\max} \qquad (19a)$$

$$C_{p2\min} \leq C_{p2} \leq C_{p2\min} + \Delta_{p2} = C_{p2\max} \qquad (19b)$$

where $\Delta_{p1}$, and $\Delta_{p2}$ are the variable capacitance ranges.

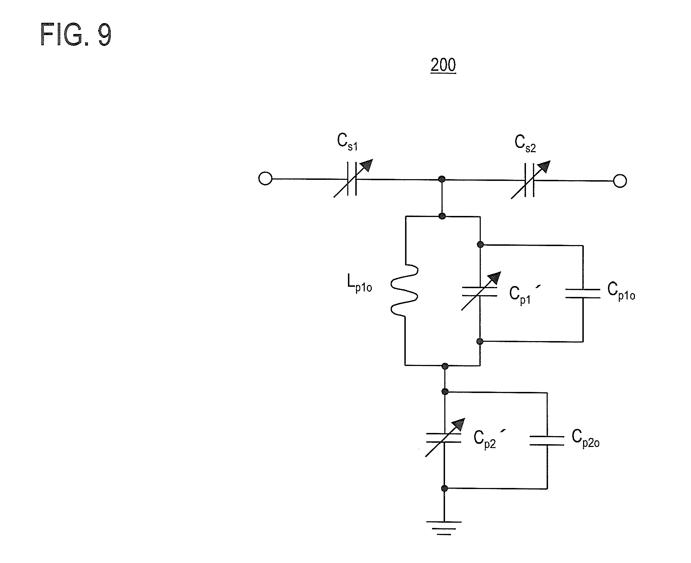

The smaller the absolute value of the capacitance of a variable capacitive element, the smaller the size of the capacitive element. In order to reduce the absolute value of the capacitance, the variable capacitive element $C_{p1}$ is formed by a fixed capacitive element $C_{p1o}$ ($0 < C_{p1o} \leq C_{p1\max} - \Delta_{p1}$) and a variable capacitive element $C_{p1}'$ provided in parallel with the fixed capacitive element $C_{p1o}$ as illustrated in Fig. 9. Similarly, the variable capacitive element $C_{p2}$ may be formed by a fixed capacitive element $C_{p2o}$ ($0 < C_{p2o} \leq C_{p2\min}$) and a variable capacitive element $C_{p2}'$ provided in parallel with the fixed capacitive element $C_{p2o}$. With this configuration, the absolute values of the capacitances of the variable capacitive elements $C_{p1}'$ and $C_{p2}'$ used can be reduced from the absolute values of the capacitances of $C_{p1}$ and $C_{p2}$ in Equations (19a) and (19b) by $C_{p1o}$ and $C_{p2o}$, respectively, as shown by Expressions given below. Accordingly, smaller variable capacitive elements can be used.

$$C_{p1\max} - C_{p1o} - \Delta_{p1} \leq C_{p1}' \leq C_{p1\max} - C_{p1o} \qquad (20a)$$

$$C_{p2\min} - C_{p2o} \leq C_{p2}' \leq C_{p2\min} + \Delta_{p2} - C_{p2o} \qquad (20b)$$

A variable susceptance range that can be obtained by changing $C_{p1}$ and $C_{p2}$ when the set of the single fixed inductive element $L_{p1o}$ and the two variable capacitive elements $C_{p1}$ and $C_{p2}$ in the configuration in Fig. 8 is caused to function as if the set were a variable inductive element will be calculated. Then, the inductance range equivalent to the variable susceptance range that would be achieved only by an inductor will be determined.

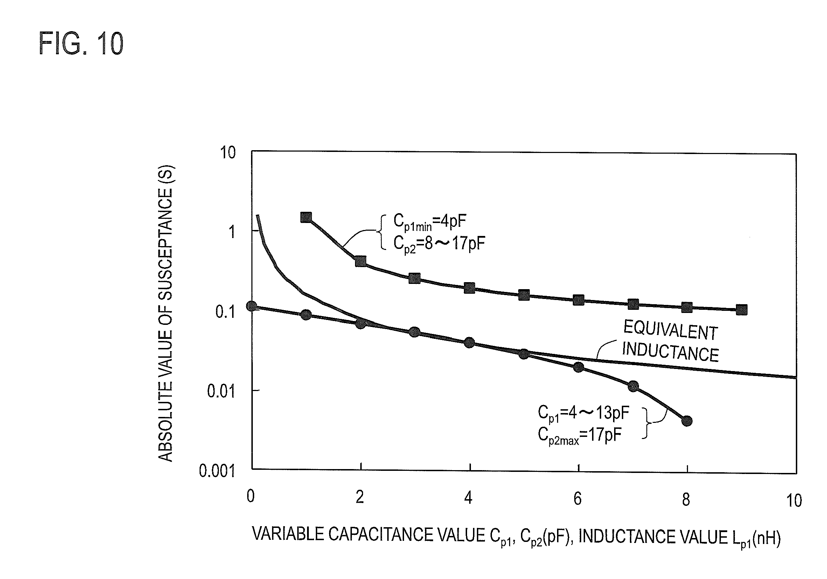

By way of illustration, required $C_{p1}$ and $C_{p2}$ when an input signal frequency is 1 GHz and $L_{p1o}$ is 2 nH will be calculated. From Expression (18a), $C_{p1\max}$ is approximately 12.7 pF. For simplicity, assume that $C_{p1\max}$ is 13 pF and $\Delta_{p1}$ is 9 pF. Then $4 \leq C_{p1} \leq 13$ pF. Here, since $C_{p1\min}$ is 4 pF, $C_{p2\min}$ is 8.7 pF or more from Expression (18b). For simplicity, assume that $C_{p2\min}$ is 8 pF and $\Delta_{p2}$ is 9 pF. Then $8 \leq C_{p2} \leq 17$ pF. Fig. 10 illustrates plots of the absolute value of susceptance in the configuration in Fig. 9 in which $C_{p1}$ in Fig. 8 is divided into two, $C_{p1}'$ and $C_{p1o}$, and $C_{p2}$ in Fig. 8 is divided into two, $C_{p2}'$ and $C_{p2o}$, where $C_{p1o} = 4$ pF, $C_{p2o} = 8$ pF, and variable capacitance values $C_{p1}'$ and $C_{p2}'$ are changed in the ranges $\Delta_{p1}$ and $\Delta_{p2}$ (0 to 9 pF), respectively (variable capacitance value versus absolute susceptance value characteristics). The filled circles represent a plot obtained by changing $C_{p1}'$ while $C_{p2}$ is fixed at $C_{p2\max}$ ($= 17$ pF) and filled squares represent a plot obtained by changing $C_{p2}'$ while $C_{p1}$ is fixed at $C_{p1\min}$ ($= 4$ pF). The solid curve without circles nor squares represents the absolute value of susceptance obtained by changing the inductance value equivalent to the variable inductive element $L_{p1}$ in Fig. 14A in the range of 0 to 10 nH. It can be seen from Fig. 10 that susceptance value adjustment in a range equivalent to a range achievable by changing the inductance value $L_{p1}$ by 10 nH or more can be achieved by changing the values of $C_{p1}$ and $C_{p2}$, when the input signal frequency = 1 GHz, $L_{p1o} = 2$nH, $C_{p1} = 4$ to 13 pF and $C_{p2} = 8$ to 17 pF.

The configuration in Fig. 14A has been changed to a configuration that does not use a variable inductive element in the second embodiment described above. The configuration in Fig. 14B also can be changed to a configuration that does not use a variable inductive element in a way similar to that in the second embodiment.

In this way, the variable impedance matching circuit 200 of the present invention is capable of adjusting impedance without using a variable inductive element as if the circuit 200 were using a variable inductive element. Accordingly, the variable impedance matching circuit is capable of dealing with variations in load in a wide range with a small number of elements. If required susceptance values are within a more limited range, $C_{p2}$ may be replaced with a fixed capacitance. Furthermore, the configurations of the variation of the first embodiment can be used in the second embodiment to configure a variable impedance matching circuit that can be used with multiple frequency bands.

[Third Embodiment]

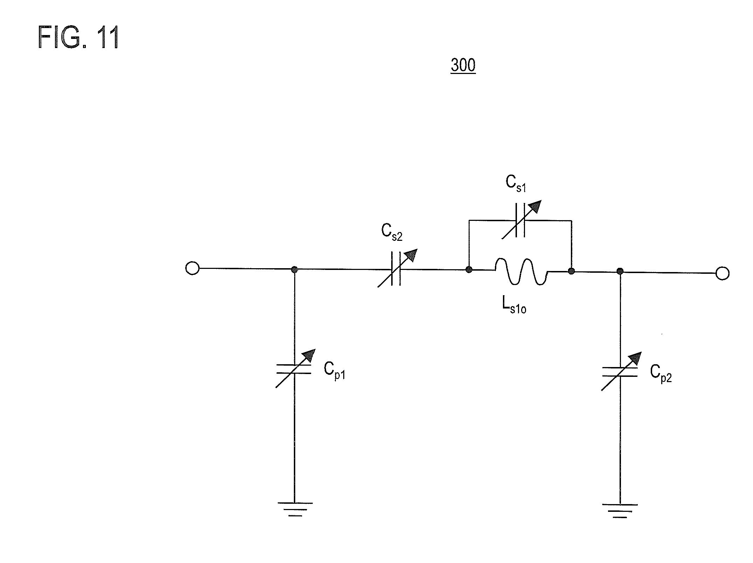

Fig. 11 illustrates an exemplary configuration of a variable impedance matching circuit 300 of the present invention. The variable impedance matching circuit 300 has a configuration in which one fixed inductive element and two variable capacitive elements together act as the variable inductive element $L_{s1}$ in the variable matching circuit in Fig. 14D.

The variable impedance matching circuit 300 includes a series connection between a parallel connection of a fixed inductive element $L_{s1o}$ and a variable capacitive element $C_{s1}$, and a variable capacitive element $C_{s2}$. The variable impedance matching circuit 300 also includes a variable capacitive element $C_{p1}$ one end of which is connected to one end of the series connection and the other end of which is grounded, and a variable capacitive element $C_{p2}$ one end of which is connected to the other end of the series connection and the other end of which is grounded.

The fixed inductive element $L_{s1o}$ is a fixed inductor with an inductance of $L_{s1o}$. The variable capacitive elements $C_{s1}$, and $C_{s2}$ are variable capacitive elements having capacitances of $C_{s1}$ and $C_{s2}$, respectively. The conditions of the elements are the same as the conditions in the second embodiment, except that the fixed inductive element $L_{p1o}$ in the second embodiment is replaced with the fixed inductive element $L_{s1o}$, the variable capacitive element $C_{p1}$ is replaced with the variable capacitive element $C_{s1}$ and the variable capacitive element $C_{p2}$ is replaced with the variable capacitive element $C_{s2}$. Alternatively, the variable capacitive element $C_{s1}$ may be formed by a parallel connection of a fixed capacitive element $C_{s1o}$ and a variable capacitive element $C_{s1}'$ having a smaller capacitance and the variable capacitive element $C_{s2}$ may be formed by a parallel connection of a fixed capacitive element $C_{s2o}$ and a variable capacitive element $C_{s2}'$ having a smaller capacitance, thereby smaller variable capacitive elements can be used. In this case, the capacitances of the fixed capacitance elements $C_{s1o}$ and $C_{s2o}$ and the variable capacitive elements $C_{s1}'$ and $C_{s2}'$ that correspond to the variable capacitive elements $C_{s1}$ and $C_{s2}$, respectively, can be calculated by replacing $C_{p1}$, $C_{p2}$, $C_{p1o}$, $C_{p2o}$, $C_{p1}'$ and $C_{p2}'$ with $C_{s1}$, $C_{s2}$, $C_{s1o}$, $C_{s2o}$, $C_{s1}'$ and $C_{s2}'$, respectively, in the method calculating $C_{p1o}$, $C_{p1}'$ and $C_{2o}$, $C_{p2}'$ that correspond to $C_{p1}$ and $C_{p2}$, respectively, described in the second embodiment.

The variable capacitive elements may be implemented by semiconductor elements or may be implemented using MEMS technology and may be manufactured and configured by any methods.

A variable reactance range that can be obtained by changing $C_{s1}$ and $C_{s2}$ when the set of the single fixed inductive element $L_{s1o}$ and the two variable capacitive elements $C_{s1}$ and $C_{s2}$ in the configuration in Fig. 11 is caused to function as if the set were a variable inductive element will be calculated. Then, the inductance range equivalent to the variable reactance range that would be achieved only by an inductor will be determined.

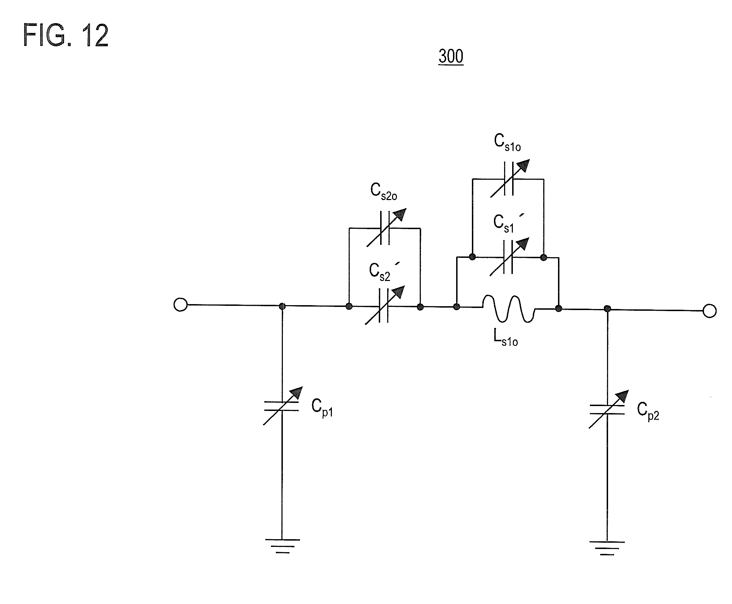

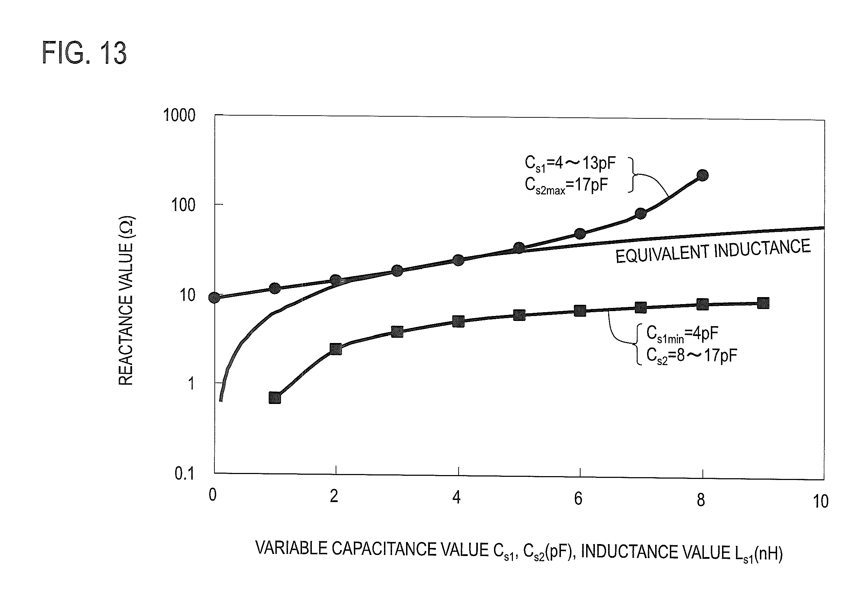

By way of illustration, required $C_{s1}$ and $C_{s2}$ when an input signal frequency is 1 GHz and $L_{s1o}$ is 2 nH will be calculated. From Expression (18a), $C_{s1max}$ is approximately 12.7 pF. For simplicity, assume that $C_{s1max}$ is 13 pF and $\Delta_{s1}$ is 9 pF. Then $4 \leq C_{s1} \leq 13$ pF. Here, since $C_{s1min}$ is 4 pF, $C_{s2}$ is 8.7 pF or more from Expression (18b). For simplicity, assume that $C_{s2min}$ is 8 pF and $\Delta_{s2}$ is 9 pF. Then $8 \leq C_{s2} \leq 17$ pF. Fig. 13 illustrates plots of reactance values in the configuration in Fig. 12 in which $C_{s1}$ in Fig. 11 is divided into two, $C_{s1}'$ and $C_{s1o}$, and $C_{s2}$ in Fig. 11 is divided into two, $C_{s2}'$ and $C_{s2o}$, where $C_{s1o} = 4$ pF, $C_{s2o} = 8$ pF, and variable capacitance values $C_{s1}'$ and $C_{s2}'$ are changed in the ranges $\Delta_{s1}$ and $\Delta_{s2}$ (0 to 9 pF), respectively (variable capacitance value versus reactance value characteristics). The filled circles represent a plot obtained by changing $C_{s1}'$ while $C_{s2}$ is fixed at $C_{s2max}$ (= 17 pF) and filled squares represent a plot obtained by changing $C_{s2}'$ while $C_{s1}$ is fixed at $C_{s1min}$ (= 4 pF). The solid curve without circles nor squares represents a reactance value obtained by changing the inductance value equivalent to the variable inductive element $L_{s1}$ in Fig. 14D in the range of 0 to 10 nH. It can be seen from Fig. 13 that reactance value adjustment in a range equivalent to a range achievable by changing the inductance value $L_{s1}$ by 10 nH or more can be achieved by changing the values of $C_{s1}$ and $C_{s2}$, when the input signal frequency = 1 GHz, $L_{s1o} = 2$nH, $C_{s1} = 4$ to 13 pF and $C_{s2} = 8$ to 17 pF.

The configuration in Fig. 14D has been changed to a configuration that does not use a variable inductive element in the third embodiment described above. The configuration in Fig. 14C also can be changed to a configuration that does not use a variable inductive element in a way similar to that in the third embodiment.

In this way, the variable impedance matching circuit 300 of the present invention is capable of adjusting impedance without using a variable inductive element as if the circuit 300 were using a variable inductive element. Accordingly, the variable impedance matching circuit 300 is capable of dealing with variations in load in a wide range with a small number of elements.

The allocations of functions of the components of the variable impedance matching circuits 100, 150, 200 and 300 of the present invention described above are not limited to those described in the embodiments. Changes can be made to the allocations as appropriate without departing from the scope of the present invention.

**Claims**

1. A variable impedance matching circuit comprising:

   a series or parallel connection of a fixed inductive element and a first variable capacitive element; and
   a second variable capacitive element connected in series with the series or parallel connection;
   wherein susceptance of the circuit can be changed by changing the capacitance of each of the variable capacitive elements.

2. The variable impedance matching circuit according to claim 1, further comprising a series connection of a third variable capacitive element and a fourth variable capacitive element;
   wherein both ends of the series connection between the series connection of the fixed inductive element and the first variable capacitive element and the second variable capacitive element are grounded; and
   a connection point of the series connection of the third variable capacitive element and the fourth variable capacitive element is connected to a connection point of the series connection between the series connection of the fixed inductive element and the first variable capacitive element and the second variable capacitive element.

3. The variable impedance matching circuit according to claim 2, further comprising:

   a first fixed capacitive element, one end of the first fixed capacitive element being connected to one end of the first variable capacitive element, the other end of the first fixed capacitive element being connected to the other end of the first variable capacitive element; and
   a second fixed capacitive element, one end of the second fixed capacitive element being connected to one end of the second variable capacitive element, the other end of the second fixed capacitive element being connected to the other end of the second variable capacitive element.

4. The variable impedance matching circuit according to claim 3, wherein:

   the capacitance value $C_{p1o}$ of the first fixed capacitive element satisfies the expressions

$$0 < C_{p1o} \leq C_{p1min}$$

$$C_{p1min} \leq \frac{1}{\omega^2 L_{p1o}}$$

   where $\omega$ is the angular frequency of an input signal, $C_{p1min}$ is a minimum value of the sum of $C_{p1o}$ and the capacitance value of the first variable capacitive element, $L_{p1o}$ is the inductance of the fixed inductive element; and
   the capacitance value $C_{p2o}$ of the second fixed capacitive element satisfies the expressions

$$0 < C_{p2o} \leq C_{p2max} - \Delta_{p2}$$

$$C_{p2\max} \geq \frac{1}{\omega^2 L_{p1o}}$$

where $C_{p2max}$ is a maximum value of the sum of $C_{p2o}$ and the capacitance value of the second variable capacitive element and $\Delta_{p2}$ is a range of variable capacitance covered by the second variable capacitive element.

5. The variable impedance matching circuit according to claim 1, further comprising:

   a series connection of a third variable capacitive element and a fourth variable capacitive element;
   wherein one end of the series connection between the parallel connection of the fixed inductive element and the first variable capacitive element and the second variable capacitive element is connected to a connection point of the series connection of the third variable capacitive element and the fourth variable capacitive element, and the other end is grounded.

6. The variable impedance matching circuit according to claim 5, further comprising:

   a first fixed capacitive element, one end of the first fixed capacitive element being connected to one end of the first variable capacitive element, the other end of the first fixed capacitive element being connected to the other end of the first variable capacitive element; and
   a second fixed capacitive element, one end of the second fixed capacitive element being connected to one end of the second variable capacitive element, the other end of the second fixed capacitive element being connected to the other end of the second variable capacitive element.

7. The variable impedance matching circuit according to claim 6, wherein:

   the capacitance value $C_{p1o}$ of the first fixed capacitive element
   satisfies the expressions

$$0 < C_{p1o} \leq C_{p1\max} - \Delta_{p1}$$

$$C_{p1\max} \geq \frac{1}{\omega^2 L_{p1o}}$$

where $\omega$ is the angular frequency of an input signal, $L_{p1o}$ is the inductance of the fixed inductive element, $C_{p1max}$ is a maximum value of the sum of $C_{p1o}$ and the capacitance value of the first variable capacitive element, and $\Delta_{p1}$ is a range of variable capacitance covered by the first variable capacitive element; and
the capacitance value $C_{p2o}$ of the second fixed capacitive element satisfies the expressions

$$0 < C_{p2o} \leq C_{p2\min}$$

$$C_{p2\min} \leq \frac{1 - \omega^2 L_{p1o} C_{p1\min}}{\omega^2 L_{p1o}}$$

$$C_{p1\min} < \frac{1}{\omega^2 L_{p1o}}$$

where $C_{p1\min}$ is a minimum value of the sum of $C_{p1o}$ and the capacitance value of the first variable capacitive element and $C_{p2\min}$ is a minimum value of the sum of $C_{p2o}$ and the capacitance value of the second variable capacitive element.

8. The variable impedance matching circuit according to claim 1, further comprising a third and fourth variable capacitive elements;
   wherein one end of the third variable capacitive element is connected to one end of the series connection between the parallel connection of the fixed inductive element and the first variable capacitive element and the second variable capacitive element, and the other end is grounded; and
   one end of the fourth variable capacitive element is connected to the other end of the series connection between the parallel connection of the fixed inductive element and the first variable capacitive element and the second variable capacitive element, and the other end is grounded.

9. The variable impedance matching circuit according to claim 8, further comprising:

   a first fixed capacitive element, one end of the first fixed capacitive element being connected to one end of the first variable capacitive element, the other end of the first fixed capacitive element being connected to the other end of the first variable capacitive element; and
   a second fixed capacitive element, one end of the second fixed capacitive element being connected to one end of the second variable capacitive element, the other end of the second fixed capacitive element being connected to the other end of the second variable capacitive element.

10. The variable impedance matching circuit according to claim 9, wherein:

   the capacitance value $C_{s1o}$ of the first fixed capacitive element satisfies the expressions

$$0 < C_{s1o} \leq C_{s1\max} - \Delta_{s1}$$

$$C_{s1\max} \geq \frac{1}{\omega^2 L_{s1o}}$$

   where $\omega$ is the angular frequency of an input signal, $L_{s1o}$ is the inductance of the fixed inductive element, $C_{s1\max}$ is a maximum value of the sum of $C_{s1o}$ and the capacitance value of the first variable capacitive element, and $\Delta_{s1}$ is a range of variable capacitance covered by the first variable capacitive element; and
   the capacitance value $C_{s2o}$ of the second fixed capacitive element satisfies the expressions

$$0 < C_{s2o} \leq C_{s2\min}$$

$$C_{s2\min} \leq \frac{1 - \omega^2 L_{s1o} C_{s1\min}}{\omega^2 L_{s1o}}$$

$$C_{s1\min} < \frac{1}{\omega^2 L_{s1o}}$$

where $C_{s1\min}$ is a minimum value of the sum of $C_{s1o}$ and the capacitance value of the first variable capacitive element and $C_{s2\min}$ is a minimum value of the sum of $C_{s2o}$ and the capacitance value of the second variable capacitive element.

FIG. 1

FIG. 2

100

EP 2 418 772 A2

FIG. 3

VARIABLE CAPACITANCE VALUE $C_{p1}$, $C_{p2}$(pF), INDUCTANCE VALUE $L_{p1}$(nH)

FIG. 4

150

# FIG. 5

FIG. 6

FIG. 7

FIG. 8

200

$C_{s1}$    $C_{s2}$

$L_{p1o}$    $C_{p1}$

$C_{p2}$

EP 2 418 772 A2

FIG. 9

FIG. 10

EP 2 418 772 A2

FIG. 11

FIG. 12

300

$C_{s1o}$

$C_{s2o}$

$C_{s1}'$

$C_{s2}'$

$L_{s1o}$

$C_{p1}$

$C_{p2}$

EP 2 418 772 A2

FIG. 13

EP 2 418 772 A2

FIG. 14A    PRIOR ART

$C_{s1}$    $C_{s2}$

$L_{p1}$

FIG. 14B    PRIOR ART

$C_{s1}$

$L_{p1}$    $L_{p2}$

FIG. 14C    PRIOR ART

$L_{s1}$    $L_{s2}$

$C_{p1}$

FIG. 14D    PRIOR ART

$L_{s1}$

$C_{p1}$    $C_{p2}$

EP 2 418 772 A2